# EUROPEAN PATENT APPLICATION

(11) **EP 4 488 722 A1**
(43) Date of publication of application: **08.01.2025**
(21) Application number: 22929538.1
(22) Date of filing: 06.09.2022
(51) Int. Cl.: G01S 17/88, H01S 5/042

(54) **LASER RADAR, AND DRIVING CIRCUIT AND DRIVING METHOD THEREFOR**

(30) Priority: 04.03.2022 CN 202210211551
(71) Applicant: Hesai Technology Co., Ltd., Shanghai 201815 (CN)
(72) Inventor: CHEN, Zhengtao, Shanghai, 201815, (CN); XIANG, Shaoqing, Shanghai, 201815, (CN)
(74) Representative: Fish & Richardson P.C.
(86) International application number: PCT/CN2022/117235
(87) International publication number: WO 2023/165107

(57) **Abstract**

A LiDAR, and drive circuits, and drive methods thereof are disclosed. The drive circuit includes: a switch controller unit configured to selectively control a light-emitter apparatus to emit light and stop emitting the light; a first monitor unit configured to monitor light-emitting energy of the light-emitter apparatus; a second monitor unit configured to monitor light-emitting duration of the light-emitter apparatus; and a safety controller unit configured to control the light-emitter apparatus to stop emitting the light by the switch controller unit when at least one of the light-emitting energy reaches a first threshold or the light-emitting duration reaches a second threshold. In technical solutions of this disclosure, a risk to human eye safety led by laser light emission can be reduced on the basis of guaranteeing working efficiency of a LiDAR.

## Description

This application claims priority to Chinese Patent Application No. 202210211551.7, filed on March 4, 2022 and entitled "LIDAR, AND DRIVE CIRCUIT AND DRIVE METHOD THEREOF" to the China National Intellectual Property Administration, the content of which is herein incorporated by reference in its entirety.

### TECHNICAL FIELD

This disclosure relates to the field of LiDAR and, in particular, to a LiDAR, and a drive circuit and a drive method thereof.

### BACKGROUND

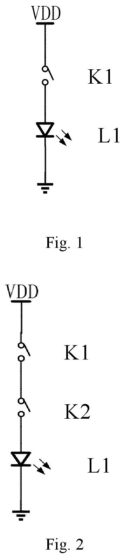

If the energy of a laser in a LiDAR exceeds a particular value, human eye tissue can be irreversibly damaged. Needs for laser energy are defined in laser safety standards, and a laser emission circuit needs to meet the needs that in the event of any single point failure (primarily switch failure), the emitted laser energy does not exceed a human eye safety threshold. A laser high side drive circuit can drive the laser to emit light, and a basic principle thereof is shown in Fig. 1. The high side drive circuit can be equivalent to a model in which a switch K1 and a laser L1 are connected in series. When the switch K1 is turned on, the laser L1 emits the light, and when the switch K1 is turned off, the laser L1 stops emitting the light. The light-emitting pulse width of the laser L1 is based on the turn-on time of the switch K1, for example, if the turn-on time of the switch is longer, the pulse is wider. The light-emitting energy of the laser is based on the on resistance of the switch and characteristics of the laser itself. When the switch is short-circuited, the laser continues to emit the light, leading to a risk to human eye safety.

To reduce the risk to the human eye safety led by the short-circuit of the switch in the laser high side drive circuit, a simplest method is to split a high side drive switch into two switches connected in series, as shown in Fig. 2. The laser L1 can only emit the light when two switches (K1 and K2) are both turned on. Therefore, the short-circuit of a single switch does not pose the risk to the human eye safety. The simultaneous short-circuit of two switches belongs to dual-point failure, which typically has an extremely low probability.

However, in some applications, for example, in a LiDAR using direct Time of Flight ("dTof") for range detection, the higher the light-emitting energy and energy efficiency of the laser, the better. If the switch has a fixed size, the on resistance of two switches connected in series is doubled compared to the on resistance of the single switch, resulting in a significant reduction in the light-emitting energy and the energy efficiency of the laser, which cannot meet application needs of the LiDAR.

### SUMMARY

Technical problems to be solved by this disclosure are to reduce a risk to human eye safety led by laser light emission on the basis of guaranteeing working efficiency of a LiDAR.

To solve the technical problems, in a first aspect, embodiments of this disclosure provide a drive circuit for a LiDAR, where the drive circuit includes: a switch controller unit, configured to selectively control a light-emitter apparatus to emit light and stop emitting the light; a first monitor unit, configured to monitor light-emitting energy of the light-emitter apparatus; a second monitor unit, configured to monitor light-emitting duration of the light-emitter apparatus; and a safety controller unit, configured to control the light-emitter apparatus to stop emitting the light by the switch controller unit when the light-emitting energy reaches a first threshold, and/or the light-emitting duration reaches a second threshold.

Optionally, the second monitor unit monitors whether voltage of the light-emitter apparatus reaches a light-emitting voltage threshold of the light-emitter apparatus.

Optionally, the drive circuit further includes: a first resistor, where the first resistor and the light-emitter apparatus are connected in parallel, and the first resistor is configured to discharge the light-emitter apparatus.

Optionally, the drive circuit further includes: a logic controller unit, configured to output a first control signal to the safety controller unit when at least one of the light-emitting energy reaches the first threshold or the light-emitting duration reaches the second threshold, where the safety controller unit controls the light-emitter apparatus to stop emitting the light based on the first control signal.

Optionally, the second monitor unit includes: a first comparison subunit configured to output a first voltage based on a comparison result between the voltage of the light-emitter apparatus and a first reference voltage, where the first voltage reflects the light-emitting duration of the light-emitter apparatus.

Optionally, the first comparison subunit includes: a first voltage division subunit, configured to divide the voltage of the light-emitter apparatus; and a first comparator, where a positive input end of the first comparator is coupled to an output end of the first voltage division subunit, a negative input end of the first comparator is connected to the first reference voltage, and an output end of the first comparator outputs the first voltage.

Optionally, the second monitor unit outputs a monitoring signal when monitoring that the light-emitting duration reaches the second threshold, where the second monitor unit further includes: a second comparison subunit, configured to output the monitoring signal based on a comparison result between the first voltage and a second reference voltage.

Optionally, the second comparison subunit includes: a first energy storage subunit configured to charge or discharge based on the first voltage; and a first controller subunit, where the first controller subunit outputs the monitoring signal when the voltage of the first energy storage subunit is greater than the second reference voltage.

Optionally, the second monitor unit further includes: a first filter subunit, coupled to an output end of the first voltage division subunit and configured to filter the divided voltage.

Optionally, the first controller subunit includes: a phase inverter, where an input end of the phase inverter is coupled to an output end of the first comparison subunit; a first MOS transistor, where a gate of the first MOS transistor is coupled to an output end of the phase inverter, a source of the first MOS transistor is grounded, and a drain of the first MOS transistor is coupled to a second end of the first energy storage subunit; a second MOS transistor, where a gate of the second MOS transistor is coupled to the output end of the phase inverter, and a source of the second MOS transistor is coupled to the second end of the first energy storage subunit; a changeable current source, where a first end of the changeable current source is connected to supply voltage, and a second end of the changeable current source is coupled to a drain of the second MOS transistor; and a second comparator, where a positive input end of the second comparator is coupled to the source of the second MOS transistor, a negative input end of the second comparator is coupled to the second reference voltage, and an output end of the second comparator outputs the monitoring signal.

Optionally, the switch controller unit includes: a second energy storage unit, where a first end of the second energy storage unit is connected to the supply voltage, and a second end of the second energy storage unit is grounded; a first switch unit, where a first end of the first switch unit is coupled to the first end of the second energy storage unit, a second end of the first switch unit is coupled to the light-emitter apparatus, and the first switch unit is configured to selectively use the second energy storage unit to drive the light-emitter apparatus to emit the light; and a second switch unit, where the second switch unit is configured to selectively discharge the second energy storage unit.

Optionally, the first monitor unit monitors whether the voltage of the first end of the second energy storage unit reaches the second threshold.

Optionally, the switch controller unit further includes: a third switch unit, where a first end of the third switch unit is connected to the supply voltage, a second end of the third switch unit is coupled to the first end of the second energy storage unit and the first end of the first switch unit, and the second end of the first switch unit is coupled to an anode of the light-emitter apparatus.

Optionally, the second switch unit includes: a third MOS transistor, where a gate of the third MOS transistor is coupled to an output end of the safety controller unit, a drain of the third MOS transistor is connected to the supply voltage, and a source of the third MOS transistor is grounded.

Optionally, the second switch unit includes: a fourth MOS transistor, where a gate of the fourth MOS transistor is connected to the first control signal, and a source of the fourth MOS transistor is connected to the first voltage; a fifth MOS transistor, where a gate of the fifth MOS transistor is connected to a second control signal, a source of the fifth MOS transistor is grounded, and a drain of the fifth MOS transistor is coupled to a drain of the fourth MOS transistor; a sixth MOS transistor, where a gate of the sixth MOS transistor is connected to the second control signal, a source of the sixth MOS transistor is connected to a second voltage, and the second voltage is less than the first voltage; and the third MOS transistor, where the gate of the third MOS transistor is coupled to a drain of the sixth MOS transistor and the drain of the fourth MOS transistor, the drain of the third MOS transistor is connected to the supply voltage, and the drain of the third MOS transistor is grounded.

Optionally, the second switch unit further includes: a first driver, where an input end of the first driver inputs a third control signal, and an output end of the first driver outputs the first control signal; and a second driver, where an input end of the second driver is coupled to the output end of the safety controller unit, and an output end of the second driver outputs the second control signal.

Optionally, the second switch unit further includes: a level shifter, where an input end of the level shifter is coupled to the output end of the safety controller unit, and an output end of the level shifter outputs the third control signal.

Optionally, the switch controller unit includes a second energy storage unit, where the second energy storage unit is configured to input charges to the light-emitter apparatus to control the light-emitter apparatus to emit the light, and the first monitor unit monitors voltage variation of the second energy storage unit.

Optionally, the first monitor unit includes: a second voltage division subunit configured to divide the supply voltage to output a voltage division signal; a digital-to-analog converter, where the digital-to-analog converter is configured to provide reference voltage; and a third comparator, where a negative input end of the third comparator is connected to the voltage division signal, and a positive input end of the third comparator is coupled to an output end of the digital-to-analog converter.

Optionally, the first monitor unit includes: a second filter subunit, coupled to an output end of the second voltage division subunit and configured to filter the voltage division signal.

In a second aspect, embodiments of this disclosure further disclose a drive method for a LiDAR, where the LiDAR includes a light-emitter apparatus, and the drive method includes: monitoring at least one of light-emitting energy of the light-emitter apparatus, or light-emitting duration of the light-emitter apparatus; and controlling the light-emitter apparatus to stop emitting light when the light-emitting energy reaches a first threshold, and/or the light-emitting duration reaches a second threshold.

Optionally, monitoring the light-emitting duration of the light-emitter apparatus includes: monitoring whether the voltage of the light-emitter apparatus reaches a light-emitting voltage threshold of the light-emitter apparatus.

In a third aspect, embodiments of this disclosure further disclose a LiDAR, where the LiDAR includes a light-emitter apparatus, and the LiDAR further includes the drive circuit.

Compared to the existing technique, technical solutions of the embodiments of this disclosure realize the following beneficial effects.

In the technical solutions of this disclosure, the drive circuit for the LiDAR includes the first monitor unit and the second monitor unit, the first monitor unit is configured to monitor the light-emitting energy of the light-emitter apparatus, and the second monitor unit is configured to monitor the light-emitting duration of the light-emitter apparatus; and the safety controller unit controls the light-emitter apparatus to stop emitting the light when the light-emitting energy reaches the first threshold, and/or the light-emitting duration reaches the second threshold. In the embodiments of this disclosure, the risk to the human eye safety led by the laser light emission can be minimized by respectively monitoring the light-emitting energy and the light-emitting duration of a high side drive light-emitter apparatus, and controlling the laser to stop emitting the light when any of the light-emitting energy and the light-emitting duration reaches a corresponding trigger threshold. Furthermore, in the technical solutions of this disclosure, there is no increase in turn-on power consumption, ensuring the light-emitting energy and energy efficiency of the light-emitter apparatus in the LiDAR.

Further, the second monitor unit monitors whether the voltage of the light-emitter apparatus reaches the light-emitting voltage threshold of the light-emitter apparatus. Because the light-emitter apparatus emits the light only when the voltage thereof reaches the light-emitting voltage threshold, in the technical solutions of this disclosure, the second monitor unit can monitor the light-emitting duration of the light-emitter apparatus by monitoring the voltage of the light-emitter apparatus and the light-emitting voltage threshold. Furthermore, when a slow leakage occurs from the switch controller unit to the light-emitter apparatus, the second monitor unit can also detect anomalies, to prevent the light-emitter apparatus from continuously emitting the light, ensuring light-emitting safety of the light-emitter apparatus.

### BRIEF DESCRIPTION OF THE DRAWINGS

Fig. 1 shows a schematic structural diagram of a laser high side drive circuit in the existing technique.
Fig. 2 shows a schematic structural diagram of another laser high side drive circuit in the existing technique.
Fig. 3 shows a schematic structural diagram of a drive circuit for a LiDAR, provided in embodiments of this disclosure.
Fig. 4 shows a timing diagram of a switch drive signal, voltage, and a laser pulse signal, provided in embodiments of this disclosure.
Fig. 5 shows a schematic structural diagram of another drive circuit for a LiDAR, provided in embodiments of this disclosure.
Fig. 6 shows a specific schematic structural diagram of a first monitor unit, provided in embodiments of this disclosure.
Fig. 7 shows a specific schematic structural diagram of a second monitor unit, provided in embodiments of this disclosure.
Fig. 8 shows a timing diagram of various signals in the second monitor unit, provided in embodiments of this disclosure.
Fig. 9 shows a specific schematic structural diagram of a second switch unit, provided in embodiments of this disclosure.
Fig. 10 shows a flow chart of a drive method for a LiDAR, provided in embodiments of this disclosure.

### DETAILED DESCRIPTION

As described in the background, in some applications, for example, in a LiDAR using direct Time of Flight ("dTof") for range detection, the higher the light-emitting energy and the energy efficiency of a laser, the better. If the switch has a fixed size, the on resistance of two switches connected in series is doubled compared to the on resistance of the single switch, resulting in a significant reduction in the light-emitting energy and the energy efficiency of the laser, which cannot meet application needs of the LiDAR.

In technical solutions of this disclosure, a drive circuit includes a switch controller unit configured to selectively control a light-emitter apparatus to emit light and stop emitting the light; a first monitor unit configured to monitor light-emitting energy of the light-emitter apparatus; a second monitor unit configured to monitor light-emitting duration of the light-emitter apparatus; and a safety controller unit configured to control the light-emitter apparatus to stop emitting the light by the switch controller unit when the light-emitting energy reaches a first threshold and/or the light-emitting duration reaches a second threshold. In the technical solutions of this disclosure, the drive circuit for the LiDAR is provided with the first monitor unit and the second monitor unit, where the first monitor unit is configured to monitor the light-emitting energy of the light-emitter apparatus, and the second monitor unit is configured to monitor the light-emitting duration of the light-emitter apparatus; and the safety controller unit controls the light-emitter apparatus to stop emitting the light when the light-emitting energy reaches the first threshold and/or the light-emitting duration reaches the second threshold. In the embodiments of this disclosure, a risk to human eye safety led by laser light emission can be minimized by respectively monitoring the light-emitting energy and the light-emitting duration, and controlling the laser to stop emitting the light when any of the light-emitting energy and the light-emitting duration reaches a corresponding trigger threshold. Furthermore, in the technical solutions of this disclosure, there is no increase in turn-on power consumption, ensuring the light-emitting energy and the energy efficiency of the LiDAR.

Further, the second monitor unit monitors whether the voltage of the light-emitter apparatus reaches the light-emitting voltage threshold of the light-emitter apparatus. Because the light-emitter apparatus emits the light only when the voltage thereof reaches the light-emitting voltage threshold, in the technical solutions of this disclosure, the second monitor unit can monitor the light-emitting duration of the light-emitter apparatus by monitoring the voltage of the light-emitter apparatus and the light-emitting voltage threshold. Furthermore, when a slow leakage occurs from the switch controller unit to the light-emitter apparatus, the second monitor unit can also detect anomalies, to avoid the light-emitter apparatus from continuously emitting the light, ensuring light-emitting safety of the light-emitter apparatus.

To make the purposes, features and advantages of this disclosure more obvious and readily understood, specific embodiments of this disclosure are described below in detail with reference to the drawings.

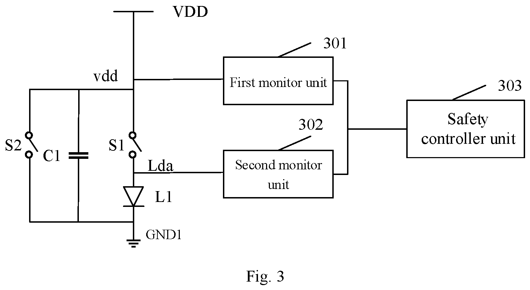

Fig. 3 shows a schematic structural diagram of a drive circuit for a LiDAR, provided in embodiments of this disclosure.

In Fig. 3, a light-emitter apparatus L1 can emit light. The light-emitter apparatus L1 can specifically be a laser, such as a vertical-cavity surface-emitting laser ("VCSEL") , or a light-emitter apparatus of any other implementable type. The number of the light-emitter apparatus L1 shown in Fig. 3 is one, while in practical application, the number of light-emitter apparatuses L1 can be multiple, and the embodiments of this disclosure are not limited thereto.

The drive circuit in these embodiments can also be called a high side drive circuit, which can drive the laser to emit the light.

In these embodiments, the switch controller unit can selectively control the light-emitter apparatus L1 to emit the light and stop emitting the light. In specific implementation, the switch controller unit can include a first switch unit, a second energy storage unit, and a second switch unit. The first switch unit and the second switch unit can be single pole single throw switches, as S1 and S2 shown in Fig. 3. The second energy storage unit can be a capacitor C1.

When the light-emitter apparatus L1 works normally, the first switch unit S1 is driven to be turned on, and the second switch unit S2 is driven to be turned off. Specifically, a power supply VDD first charges the capacitor C1, then the first switch unit S1 is turned on, and the capacitor C1 is discharged to drive the light-emitter apparatus L1 to emit the light. The light-emitting energy of the light-emitter apparatus L1 is mainly from charges stored in the capacitor C1, and voltage variation on a node vdd of the capacitor C1 (i.e., voltage variation between energy storage voltage of the capacitor C1 and the voltage of the capacitor C1 after light emission) can reflect the light-emitting energy of the light-emitter apparatus L1.

Therefore, a first monitor unit 301 can monitor the light-emitting energy of the light-emitter apparatus L1 by monitoring the voltage variation on the node vdd of the capacitor C1. Typically, when the capacitor C1 is fully charged, the voltage variation on the node vdd is actually a difference value between the voltage when the capacitor C1 is fully charged (i.e., the voltage before the light-emitter apparatus L1 emits the light) and the voltage after the light-emitter apparatus L1 emits the light. Because the voltage is fixed when the capacitor C1 is fully charged, the voltage variation on the node vdd can be the voltage of the capacitor C1 that is detected after the light-emitter apparatus L1 emits the light.

When the voltage of the node vdd is higher than a determined safety threshold, it represents that the light-emitting energy reaches the first threshold. In such a case, a human eye safety protection state is entered, and a safety controller unit 303 controls the light-emitter apparatus L1 to stop emitting the light by the switch controller unit. Specifically, the safety controller unit 303 drives the first switch unit S1 to be turned off and the second switch unit S2 to be turned on to ground the capacitor C1 to GND1. Thus, the capacitor C1 is discharged and the voltage of the node vdd is lowered, that is, the light-emitting energy of the light-emitter apparatus L1 is reduced to control the light-emitter apparatus L1 to stop emitting the light. In this case, even if the first switch unit S1 is short-circuited, the light-emitter apparatus L1 does not continuously emit the light, reducing the risk to the human eye safety led by the laser light emission.

However, when a leakage occurs in the first switch unit S1 (i.e., the switch is only burned a little, and short-circuit situation is not serious), and the capacitor C1 is charged, the leakage to the light-emitter apparatus L1 also occurs via the first switch unit S1, and the light-emitter apparatus L1 continuously emits the light with a small light intensity. This is because the voltage of the power supply VDD is very high (e.g., 30V), balanced voltage of charging and discharging the capacitor C1 after the leakage can be greater than the light-emitting voltage threshold of the light-emitter apparatus L1. In such a case, charging current and discharging current on the capacitor C1 are balanced, and the voltage variation on the node vdd is extremely low. The first monitor unit 301 can fail to detect that the light-emitting energy reaches the first threshold, but the light-emitter apparatus L1 continuously emits the light, which still poses the risk to the human eye safety.

To reduce the occurrence of the situation, in the embodiments of this disclosure, the drive circuit is further provided with a second monitor unit 302. The second monitor unit 302 can monitor the light-emitting duration of the light-emitter apparatus L1. When the light-emitting duration of the light-emitter apparatus L1 reaches the second threshold, the safety controller unit 303 can also control the light-emitter apparatus L1 to stop emitting the light by the switch controller unit.

In a specific embodiment, the second monitor unit 302 monitors whether the voltage of the light-emitter apparatus L1 reaches a light-emitting voltage threshold of the light-emitter apparatus L1. Optionally, the second monitor unit 302 monitors whether anode voltage of the light-emitter apparatus L1 reaches the light-emitting voltage threshold.

Specifically, a light-emitting principle of the light-emitter apparatus L1 determines that, when the light-emitter apparatus L1 emits the light, the voltage of an anode Lda needs to be greater than the light-emitting voltage threshold of the light-emitter apparatus, for example, the light-emitting voltage threshold of a three-layer VCSEL laser is about 5V. Therefore, the second monitor unit 302 can directly and accurately determine the light-emitting duration of the light-emitter apparatus L1 by monitoring the voltage of the anode Lda. In other words, the duration for which the voltage of the anode Lda reaches the light-emitting voltage threshold is the light-emitting duration of the light-emitter apparatus L1.

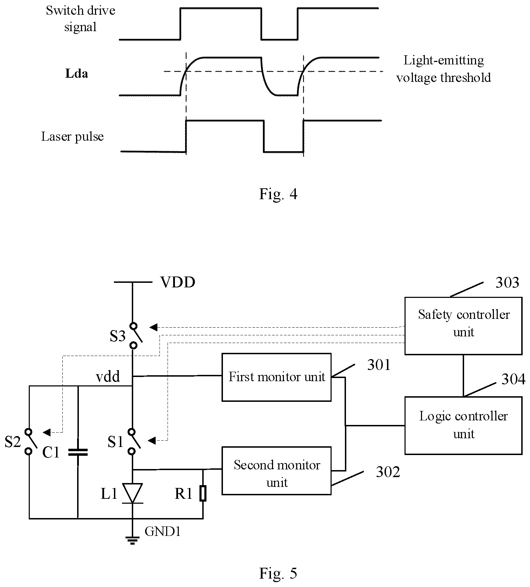

With reference to Figs. 3 and 4, a switch drive signal of the first switch unit S1 is a square wave signal. When the switch drive signal is at a high level, the first switch unit S1 is turned on, the voltage of the anode Lda of the light-emitter apparatus L1 gradually increases, and when the voltage reaches the light-emitting voltage threshold, the light-emitter apparatus L1 emits the light. After the first switch unit S1 is turned off, the voltage of the anode Lda gradually reduces, and when the voltage reaches below the light-emitting voltage threshold, the light-emitter apparatus L1 stops emitting the light. The pulse width of a laser pulse can represent the light-emitting duration of the light-emitter apparatus L1.

When the light-emitter apparatus L1 works normally, the capacitor C1 is first charged, then the first switch unit S1 is turned on, and the capacitor C1 is discharged to drive the light-emitter apparatus L1 to emit the light. When the first monitor unit 301 detects that the light-emitting energy of the light-emitter apparatus L1 reaches the first threshold, and/or the second monitor unit 302 detects that the light-emitting duration reaches the second threshold, the safety controller unit 303 controls the light-emitter apparatus L1 to stop emitting the light. Due to the use of a combined manner of monitoring the light-emitting energy and the light-emitting duration, in the case that the slow leakage occurs from the switch controller unit to the light-emitter apparatus, the light-emitting energy does not reach the first threshold, but the light-emitter apparatus continuously emits the light, the second monitor unit can also detect the anomalies by monitoring the light-emitting duration, ensuring the reliability of monitoring.

In these embodiments, the safety controller unit 303 controlling the light-emitter apparatus L1 to stop emitting the light includes that the safety controller unit 303 controls the first switch unit S1 to be turned off and controls the second switch unit S2 to be turned on, the capacitor C1 is grounded and discharged, and the light-emitter apparatus L1 stops emitting the light. Accordingly, the safety controller unit 303 controlling the light-emitter apparatus L1 to emit the light means that the capacitor C1 is charged, the safety controller unit 303 controls the first switch unit S1 to be turned on and controls the second switch unit S2 to be turned off, the capacitor C1 communicates with the light-emitter apparatus L1 and is discharged, and the light-emitter apparatus L1 is driven to emit the light.

Among them, when it is ensured that the voltage of the anode Lda of the light-emitter apparatus L1 is discharged below the light-emitting voltage threshold, the smaller the capacitance value of the capacitor C1 that meets requirements, the better. This is because the smaller the capacitance value, the faster the discharging speed of the capacitor C1, and the shorter the light-emitting duration of the light-emitter apparatus L1. That is to say, the light-emitting duration of the light-emitter apparatus L1 is determined by the discharging speed of the capacitor C1 (i.e., the capacitance value of the capacitor C1.)

It can be understood that, specific numerical values of the first threshold and the second threshold can be determined based on an actual application scenario, and the embodiments of this disclosure are not limited thereto.

In a non-limiting embodiment, due to the existence of a parasitic capacitor in the light-emitter apparatus L1 and the first switch unit S1, the anode Lda typically has a large parasitic capacitor, and the anode Lda takes a long time to be slowly discharged to zero after the light-emitter apparatus L1 stopping emitting the light. With reference to Figs. 3, 4 and 5, in the embodiments of this disclosure, a first resistor R1 is provided to enable the anode Lda to be quickly discharged, to cause the light-emitting duration of the light-emitter apparatus L1 to be correctly reflected.

Specifically, a first end of the first resistor R1 is coupled to an anode of the light-emitter apparatus L1 and an input end of the second monitor unit 302, and a second end of the first resistor R1 is grounded.

It should be noted that the first resistor R1 can also be replaced with a switch device. The safety controller unit 303 controls the switch device to be turned on to quickly discharge the anode Lda when the light-emitting energy reaches the first threshold and/or the light-emitting duration of the light-emitter apparatus L1 reaches the second threshold.

In a non-limiting embodiment, still with reference to Fig. 5, the drive circuit can further include a logic controller unit 304. The logic controller unit 304 is configured to output a first control signal to the safety controller unit 303 when the light-emitting energy reaches the first threshold and/or the light-emitting duration of the light-emitter apparatus L1 reaches the second threshold, and the safety controller unit 303 controls the light-emitter apparatus L1 to stop emitting the light based on the first control signal.

In some specific implementations, the logic controller unit 304 can be an OR gate. When the first monitor unit 301 detects that the light-emitting energy of the light-emitter apparatus L1 reaches the first threshold, the first monitor unit 301 outputs a high level signal. When the second monitor unit 302 detects that the light-emitting duration reaches the second threshold, the second monitor unit 302 outputs the high level signal.

When the first monitor unit 301 detects that the light-emitting energy of the light-emitter apparatus L1 reaches the first threshold and/or the second monitor unit 302 detects that the light-emitting duration reaches the second threshold, it represents that when one of the first monitor unit 301 and the second monitor unit 302 outputs a high level 1, the OR gate outputs the first control signal. The first control signal can be at the high level 1. In response to the first control signal, the safety controller unit 303 controls the light-emitter apparatus L1 to stop emitting the light.

In a specific embodiment, the switch controller unit includes the first switch unit S1, the second switch unit S2, a third switch unit S3, and the capacitor C1. The third switch unit S3 can control the charging of the capacitor C1. Specifically, when the third switch unit S3 is turned on, the power supply VDD charges the capacitor C1, and when the third switch unit S3 is turned off, the power supply VDD stops charging the capacitor C1.

In these embodiments, the safety controller unit 303 controlling the light-emitter apparatus L1 to stop emitting the light includes that the safety controller unit 303 controls the third switch unit S3 to be turned off, controls the first switch unit S1 to be turned off, and controls the second switch unit S2 to be turned on, the capacitor C1 is grounded and discharged, and the light-emitter apparatus L1 stops emitting the light. Accordingly, the safety controller unit 303 controlling the light-emitter apparatus L1 to emit the light includes that the safety controller unit 303 controls the third switch unit S3 to be turned on, and the capacitor C1 is charged; and the safety controller unit 303 controls the first switch unit S1 to be turned on, controls the second switch unit S2 to be turned off, the capacitor C1 communicates with the light-emitter apparatus L1 and is discharged, and the light-emitter apparatus L1 is driven to emit the light.

In a non-limiting embodiment of this disclosure, an input end of the first monitor unit 301 is connected to supply voltage, which can specifically be directly connected to the supply voltage, or can also be connected to the supply voltage by the third switch unit S3 (as shown in Fig. 5.)

It is assumed that the voltage connected to the input end of the first monitor unit 301 is vdd. Because drive voltage of the light-emitter apparatus L1 is typically large, for example, the drive voltage of the light-emitter apparatus L1 is typically 30-40V, and withstand voltage of a comparator is typically 5V, voltage division needs to be performed on the vdd. The first monitor unit 301 is provided with a second voltage division subunit to perform the voltage division on the voltage vdd connected to the input end of the first monitor unit 301.

In some specific implementation, with reference to Figs. 3 to 6, the second voltage division subunit can include a capacitor C2 and a capacitor C4, where a first end of the capacitor C4 is connected to the voltage vdd, a second end of the capacitor C4 is coupled to a first end of the capacitor C2, a second end of the capacitor C2 is grounded, and the second end of the capacitor C4 and the first end of the capacitor C2 output voltage division signals. A resistor R3 is configured to provide a direct current bias. Voltage VREF is bias voltage and is also reference voltage of a digital-to-analog converter DAC. As the bias voltage, VREF is configured to shift an input signal to an input range of the digital-to-analog converter DAC.

It should be noted that the second voltage division subunit can also perform the voltage division using a resistor, that is, the capacitor C2 and the capacitor C4 can be respectively replaced with two resistors, and details are not described herein again.

In these embodiments, the first monitor unit 301 further includes the digital-to-analog converter DAC and a third comparator CMP. The reference voltage outputted by the digital-to-analog converter DAC is any value between 0 and VREF, and VREF is the bias voltage. As the first threshold, the reference voltage outputted by the digital-to-analog converter DAC can be adaptively changed. A negative input end of the third comparator CMP is connected to the voltage division signal, and a positive input end of the third comparator CMP is coupled to an output end of the digital-to-analog converter DAC. When the third comparator CMP outputs the high level, it represents that the first monitor unit 301 detects that the voltage variation on the node vdd exceeds a determined threshold. In such a case, the safety controller unit 303 controls the light-emitter apparatus L1 to stop emitting the light.

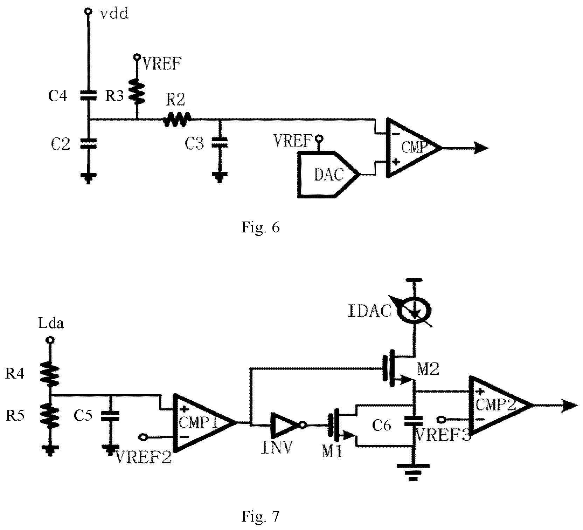

Further, the first monitor unit 301 can further include a second filter subunit configured to filter the voltage division signal. Still with reference to Fig. 6, the second filter subunit includes a resistor R2 and a capacitor C3. The second filter subunit can filter glitches and high-frequency noises on the voltage division signal, and inputs the voltage division signal to the negative input end of the third comparator CMP. Among them, a purpose of the first monitor unit 301 monitoring the node vdd is to determine the light-emitting energy of the light-emitter apparatus L1, to cause the signal to be transmitted faster by performing low-pass filter on the voltage division signal.

In a non-limiting embodiment of this disclosure, the second monitor unit 302 can include: a first comparison subunit configured to output a first voltage based on a comparison result between the voltage of the light-emitter apparatus L1 and a first reference voltage, where the first voltage reflects the light-emitting duration of the light-emitter apparatus L1. Therefore, a monitoring signal can be outputted based on the first voltage outputted by the first comparison subunit, and the safety controller unit 303 can control the light-emitter apparatus L1 to stop emitting the light in response to the monitoring signal.

Further, with referrence to Fig. 7, the first comparison subunit includes a first voltage division subunit and a first comparator CMP 1. The first voltage division subunit includes a resistor R4 and a resistor R5, where a first end of the resistor R5 is grounded, a second end of the resistor R5 is coupled to a first end of the resistor R4, and a second end of the resistor R4 is coupled to the anode lda of the light-emitter apparatus L1. The second end of the resistor R5 and the first end of the resistor R4 are used as output ends of the first voltage division subunit to output the divided voltage.

A positive input end of the first comparator CMP1 is coupled to the output end of the voltage division subunit, a negative input end of the first comparator CMP1 is connected to a first reference voltage VREF2, and an output end of the first comparator CMP1 outputs the first voltage.

Further, the second monitor unit 302 further includes a first filter subunit, where the first filter subunit is coupled to the output end of the first voltage division subunit and is configured to filter the divided voltage. With reference to Fig. 7 for details, the first filter subunit includes the resistor R5 and a capacitor C5.

The voltage of the anode Lda of the light-emitter apparatus L1 enters the positive input end of the first comparator CMP1 by passing through a direct-current voltage division and low-pass filter circuit formed by the resistor R4, the resistor R5, and the capacitor C5, and is compared to the first reference voltage VREF2. The width of a digital signal outputted by the first comparator CMP1 can represent the light-emitting pulse width of the light-emitter apparatus L1, reflecting the length of the light-emitting duration of the light-emitter apparatus L1.

Further, the second monitor unit 302 outputs the monitoring signal when monitoring that the light-emitting duration reaches the second threshold. The second monitor unit 302 further includes a second comparison subunit configured to output the monitoring signal based on a comparison result between the first voltage and a second reference voltage. Specifically, for example, the monitoring signal is outputted when the first voltage is greater than the second reference voltage, and the monitoring signal can be the high level signal.

In a specific embodiment, the second comparison subunit (also called a pulse width comparator) includes a first energy storage subunit and a first controller subunit. The first controller subunit is configured to output the monitoring signal when the voltage of the first energy storage subunit is greater than the second reference voltage.

Specifically, still with reference to Fig. 7, the first controller subunit includes a phase inverter INV, a first MOS transistor M1, a second MOS transistor M2, a changeable current source IDAC, and a second comparator CMP2. The first energy storage subunit includes a capacitor C6.

Specifically, the changeable current source IDAC controls charging speed of the capacitor C6, that is, the higher the output current, the faster the charging rate and the shorter the trigger time to make the voltage of capacitor C6 greater than the second reference voltage. Therefore, the trigger time can be determined based on the current intensity of the changeable current source IDAC. The trigger time determines the speed of the safety controller unit 303 activating a protection mechanism, to cause the length of the light-emitting duration of the light-emitter apparatus L1 to be determined.

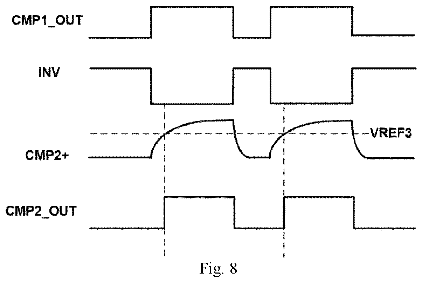

Specifically, one of the first MOS transistor M1 and the second MOS transistor M2 is controlled to be turned on and the other one is controlled to be turned off, based on output signals of the first comparator CMP1 and the phase inverter INV. Specifically, with reference to Figs. 7 and 8, when an output end CMP 1_OUT of the first comparator CMP1 outputs the high level and the phase inverter INV outputs a low level, the second MOS transistor M2 is turned on, the first MOS transistor M1 is turned off, the current source IDAC charges the capacitor C6, and the voltage of a positive input end CMP2+ of the second comparator CMP2 gradually increases. When the voltage of the positive input end CMP2+ of the second comparator CMP2 is greater than the second reference voltage VREF3, an output end CMP2_OUT of the second comparator CMP2 outputs the high level, and the second monitor unit 302 outputs the monitoring signal, such as the high level. In such a case, the safety controller unit 303 controls the light-emitter apparatus L1 to stop emitting the light. Therefore, when the leakage occurs in the first switch unit S 1, the light-emitter apparatus L1 continuously emits the light. Accordingly, the first comparator CMP1 and the second comparator CMP2 successively output the high level, and the safety controller unit 303 activates the protection mechanism to control the light-emitter apparatus L1 to stop emitting the light.

Still with reference to Fig. 8, when the output end CMP1_OUT of the first comparator CMP1 outputs the low level and the phase inverter INV outputs the high level, the first MOS transistor M1 is turned on, the second MOS transistor M2 is turned off, and the capacitor C6 is discharged. The voltage of the positive input end CMP2+ of the second comparator CMP2 gradually reduces. When the voltage of the positive input end CMP2+ of the second comparator CMP2 is less than the second reference voltage VREF3, the output end CMP2_OUT of the second comparator CMP2 outputs the low level.

In a non-limiting embodiment, as described, with reference to Fig. 3, the switch controller unit can include the first switch unit S1, the second energy storage unit C1, and the second switch unit S2.

In another non-limiting embodiment, as described above, with reference to Fig. 5, the switch controller unit can include the first switch unit S1, the second energy storage unit C1, the second switch unit S2, and the third switch unit S3.

It should be noted that the first switch unit, the second switch unit, and the third switch unit can be single pole single throw switches, or can also be any other implementable switch devices, such as PMOS transistors, the second energy storage unit can also be any other implementable energy storage device, and the embodiments of this disclosure are not limited thereto.

In a specific embodiment, the second switch unit S2 can include a third MOS transistor, where a gate of the third MOS transistor is coupled to an output end of the safety controller unit 303, a drain of the third MOS transistor is connected to the power supply VDD, and a source of the third MOS transistor is grounded.

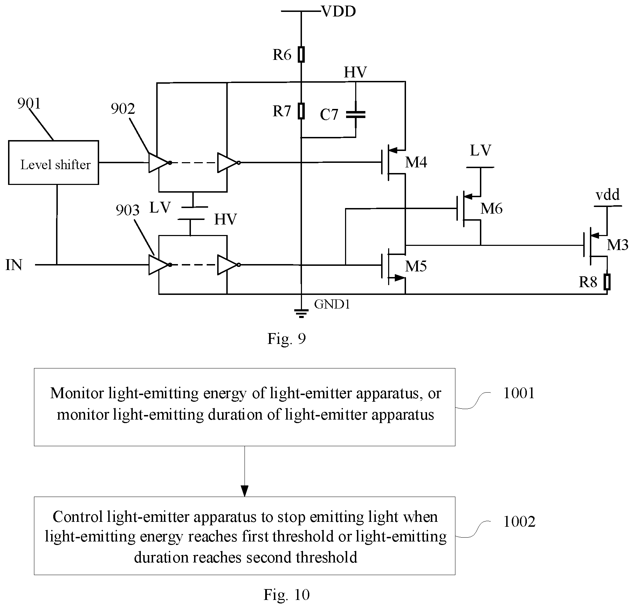

In another specific embodiment, with reference to Figs. 3 and 9, the second switch unit S2 can include a third MOS transistor M3, a fourth MOS transistor M4, a fifth MOS transistor M5, and a sixth MOS transistor M6, where a gate of the fourth MOS transistor M4 is connected to the first control signal, and a source of the fourth MOS transistor is connected to a first voltage HV; a gate of the fifth MOS transistor M5 is connected to a second control signal, a source of the fifth MOS transistor M5 is grounded, and a drain of the fifth MOS transistor M5 is coupled to a drain of the fourth MOS transistor M4; and a gate of the sixth MOS transistor M6 is connected to the second control signal, a source of the sixth MOS transistor M6 is connected to a second voltage LV, and the second voltage LV is less than the first voltage HV. Among them, when the third MOS transistor M3 is turned on, the node vdd is grounded, to cause the voltage of the node vdd to be discharged, that is, the capacitor C1 is discharged, to control the light-emitter apparatus L1 to stop emitting the light.

The first voltage HV can be determined by performing the voltage division on the power supply VDD. Specifically, the first voltage HV can be determined by performing the voltage division on a resistor R6 and a resistor R7. The voltage of the power supply VDD is typically high, such as 30V The first voltage HV (e.g., 8V) is determined by performing the voltage division on the resistor R6 and the resistor R7. To control the third MOS transistor M3 to be quickly turned on (e.g., turned on at 5V), the third MOS transistor needs to be driven by the first voltage HV (gate voltage).

Further, the second switch unit S2 can include a first driver 902 and a second driver 903, where an input end of the first driver 902 inputs a third control signal, and an output end of the first driver 902 outputs the first control signal to control the turning on of the fourth MOS transistor M4; and an input end of the second driver 903 is coupled to the output end of the safety controller unit 303, and an output end of the second driver 903 outputs the second control signal to control the turning on of the fifth MOS transistor M5.

Specifically, the first driver 902 and the second driver 903 can respectively include multiple phase inverters. The multiple phase inverters form a driver to enhance drive capability. When an output signal IN of the output end of the safety controller unit 303 is at the low level, the voltage of the output signal IN is 0V, the fifth MOS transistor M5 is turned off, and the sixth MOS transistor M6 is turned on. The voltage connected to the input end of the first driver 902 is the second voltage LV, and the fourth MOS transistor M4 is turned on, to cause the third MOS transistor M3 to be driven to be turned on. Among them, the sixth MOS transistor M6 can prevent a gate of the third MOS transistor M3 from being continuously applied with the first voltage HV, to keep the third MOS transistor M3 away from failing. Instead, the voltage can be reduced to the second voltage LV after the first voltage HV is applied to the gate of the third MOS transistor M3 for a period.

Specifically, when the voltage of the output signal IN is 0V, the fifth MOS transistor M5 is turned off, the sixth MOS transistor M6 is turned on, and the fourth MOS transistor M4 is turned on, a current path is formed between the first voltage HV and the second voltage LV because the first voltage HV is higher than the second voltage LV. Therefore, the gate of the third MOS transistor M3 is first driven by the first voltage HV, and then gradually driven by the second voltage LV through discharging.

When the output signal IN of the output end of the safety controller unit 303 is at the high level, the voltage of the output signal IN is the second voltage LV, the fifth MOS transistor M5 is turned on, and the sixth MOS transistor M6 is turned off. The voltage connected to the input end of the first driver 902 is the first voltage HV, and the fourth MOS transistor M4 is turned off, to cause the third MOS transistor M3 to be driven to be turned off.

In a specific embodiment, still with reference to Fig. 9, the second switch unit further includes a level shifter 901. The level shifter 901 can specifically realize level shifting using a current mirror circuit, that is, the output signal IN within a range of 0-LV can be determined as the third control signal within a range of LV-HV to be outputted to the first driver 902, thereby driving the turning on and turning off of the fourth MOS transistor M4.

Specifically, when the voltage of the output signal IN of the output end of the safety controller unit 303 is at the low level, output voltage of the level shifter 901 is the second voltage LV. When the voltage of the output signal IN of the output end of the safety controller unit 303 is at the high level, the output voltage of the level shifter 901 is the first voltage HV.

In these embodiments, a structure of the second switch unit S2 can improve the current capability of the third MOS transistor to accelerate the discharging speed of the capacitor C1, to cause time for triggering a human eye safety protection mechanism until the light-emitter apparatus stops emitting the light to be shortened, thereby further reducing the risk to the human eye safety led by the laser light emission.

With reference to Fig. 10, embodiments of this disclosure further disclose a drive method for a LiDAR, where the drive method can specifically include the following steps.

At S1001, light-emitting energy of a light-emitter apparatus is monitored, and/or, a light-emitting duration of the light-emitter apparatus is monitored.

At S1002, the light-emitter apparatus is controlled to stop emitting light when the light-emitting energy reaches a first threshold and/or the light-emitting duration reaches a second threshold.

It can be understood that, in some specific implementation, the drive method can be implemented in the form of a software program, which runs in a processor integrated inside a chip or a chip module. The method can also be implemented in a combined manner of software and hardware, which is not limited in this disclosure.

In the specific implementation of S1001, whether the voltage of the light-emitter apparatus reaches a light-emitting voltage threshold of the light-emitter apparatus can be monitored.

Embodiments of this disclosure further disclose a LiDAR. The LiDAR includes at least one light-emitter apparatus. The LiDAR emits a detection beam by multiple light-emitter apparatuses. The LiDAR further includes the drive circuit based on any of the embodiments. The LiDAR can control the light-emitter apparatus to emit the light or stop emitting the light by the drive circuit.

Further, the LiDAR further includes multiple light-receiving apparatuses. The multiple light-receiving apparatuses are configured to receive an echo beam of the detection beam reflected by an obstacle, and the multiple light-receiving apparatuses are provided in correspondence with the multiple light-emitter apparatuses, respectively.

It should be understood that, the term "and/or" in this disclosure is merely an association relationship describing related objects, which means that there can be three relationships, for example, A and/or B can represent three situations: A exists alone, A and B exist at the same time, and B exists alone. In addition, the character "/" in this disclosure represents that the related objects are in an "or" relationship.

"Multiple" described in the embodiments of this disclosure means two or more.

The "first," "second," or the like described in the embodiments of this disclosure are only for the purpose of illustrating and distinguishing objects described, and are not in any order, nor do they represent any special limitation on the number of devices in the embodiments of this disclosure, and cannot constitute any limitation on the embodiments of this disclosure.

The "connection" in the embodiments of this disclosure include various connection modes, such as direct connection and indirect connection, to realize a communication between devices, and the embodiments of this disclosure do not make any limitation.

The embodiments can be implemented in whole or in part by software, hardware, firmware, or any other combinations. When the software is used for implementation, the embodiments can be implemented in whole or in part in the form of a computer program product. The computer program product includes one or more computer instructions or computer programs. When the computer instructions or computer programs are loaded or executed on a computer, processes or functions based on the embodiments of this disclosure are generated in whole or in part. The computer can be a general computer, a special computer, a computer network, or other programmable apparatus. The computer instructions can be stored in a computer-readable storage medium or transmitted from one computer-readable storage medium to another computer-readable storage medium. For example, the computer instructions can be transmitted from a website site, computer, server, or data center to another website site, computer, server, or data center in a wired or wireless manner. The computer-readable storage medium can be any available medium that can be accessed by a computer, or a data storage device such as a server or data center that includes one or more available mediums integrated.

In several embodiments provided in this disclosure, it should be understood that the disclosed method, apparatus, and system can be implemented in other manners. For example, the device embodiment described is only schematic; for example, division of the units is only logic function division, and other division manners can be adopted during practical implementation; and for example, multiple units or components can be combined or integrated into another system, or some characteristics can be neglected or not executed. In addition, the displayed or discussed mutual coupling or direct coupling or communication connection can be indirect coupling or communication connection through some interfaces, devices, or units, and can be in electrical, mechanical, or other forms.

The units described as separate components can or can not be physically separated. The components displayed as units can or can not be physical units, that is, the components can be located in one place, or can also be arranged on multiple network units. Part or all of the units can be selected based on actual needs to realize the purposes of the solutions of this embodiment.

In addition, the functional units in the various embodiments of this disclosure can be integrated into one processing unit, or each unit can exist alone physically, or two or more units can be integrated into one unit. The integrated unit can be implemented in a hardware form, or can also be implemented in the form of hardware and software functional units.

The integrated unit implemented in the form of a software functional unit described can be stored in a computer-readable storage medium. The software functional unit is stored in a storage medium, and includes multiple instructions configured to cause a computer device (which can be a personal computer, a server, a network device, or the like) to execute part of the steps of the method described in various embodiments of this disclosure.

Although this disclosure is disclosed as above, this disclosure is not limited thereto. Any person skilled in the art can make various changes and modifications without departing from the spirit and scope of this disclosure. Therefore, the protection scope of this disclosure should be subject to the scope defined by the claims.

## Claims

1. A drive circuit for a LiDAR, wherein the LiDAR comprises a light-emitter apparatus, and the drive circuit comprises:
a switch controller unit, configured to selectively control a light-emitter apparatus to emit light and stop emitting the light;
a first monitor unit, configured to monitor light-emitting energy of the light-emitter apparatus;
a second monitor unit, configured to monitor light-emitting duration of the light-emitter apparatus; and
a safety controller unit, configured to control the light-emitter apparatus to stop emitting the light by the switch controller unit when the light-emitting energy reaches a first threshold, and/or the light-emitting duration reaches a second threshold.

2. The drive circuit of claim 1, wherein the second monitor unit monitors whether voltage of the light-emitter apparatus reaches a light-emitting voltage threshold of the light-emitter apparatus.

3. The drive circuit of claim 1, further comprising:
a first resistor, wherein the first resistor and the light-emitter apparatus are connected in parallel, and the first resistor is configured to discharge the light-emitter apparatus.

4. The drive circuit of claim 1, further comprising:
a logic controller unit, configured to output a first control signal to the safety controller unit when the light-emitting energy reaches the first threshold, and/or the light-emitting duration reaches the second threshold, wherein the safety controller unit controls the light-emitter apparatus to stop emitting the light based on the first control signal.

5. The drive circuit of claim 1, wherein the second monitor unit comprises:
a first comparison subunit, configured to output a first voltage based on a comparison result between the voltage of the light-emitter apparatus and a first reference voltage, wherein the first voltage reflects the light-emitting duration of the light-emitter apparatus.

6. The drive circuit of claim 5, wherein the first comparison subunit comprises:
a first voltage division subunit configured to divide the voltage of the light-emitter apparatus; and
a first comparator, wherein a positive input end of the first comparator is coupled to an output end of the first voltage division subunit, a negative input end of the first comparator is connected to the first reference voltage, and an output end of the first comparator outputs the first voltage.

7. The drive circuit of claim 6, wherein the first comparison subunit further comprises:
a first filter subunit, coupled to an output end of the first voltage division subunit and configured to filter the divided voltage.

8. The drive circuit of claim 5, wherein the second monitor unit outputs a monitoring signal when monitoring that the light-emitting duration reaches the second threshold, and the second monitor unit further comprises:
a second comparison subunit, configured to output the monitoring signal based on a comparison result between the first voltage and a second reference voltage.

9. The drive circuit of claim 8, wherein the second comparison subunit comprises:
a first energy storage subunit, configured to charge or discharge based on the first voltage; and
a first controller subunit, wherein the first controller subunit outputs the monitoring signal when the voltage of the first energy storage subunit is greater than the second reference voltage.

10. The drive circuit of claim 9, wherein the first controller subunit comprises:
a phase inverter, wherein an input end of the phase inverter is coupled to an output end of the first comparison subunit;
a first MOS transistor, wherein a gate of the first MOS transistor is coupled to an output end of the phase inverter, a source of the first MOS transistor is grounded,
and a drain of the first MOS transistor is coupled to a second end of the first energy storage subunit;
a second MOS transistor, wherein a gate of the second MOS transistor is coupled to the output end of the phase inverter, and a source of the second MOS transistor is coupled to the second end of the first energy storage subunit;
a changeable current source, wherein a first end of the changeable current source is connected to supply voltage, and a second end of the changeable current source is coupled to a drain of the second MOS transistor; and
a second comparator, wherein a positive input end of the second comparator is coupled to the source of the second MOS transistor, a negative input end of the second comparator is coupled to the second reference voltage, and an output end of the second comparator outputs the monitoring signal.

11. The drive circuit of claim 1, wherein the switch controller unit comprises a second energy storage unit, the second energy storage unit is configured to input charges to the light-emitter apparatus to control the light-emitter apparatus to emit the light, and the first monitor unit monitors voltage variation of the second energy storage unit.

12. The drive circuit of claim 11, wherein the switch controller unit comprises:
the second energy storage unit, wherein a first end of the second energy storage unit is connected to the supply voltage, and a second end of the second energy storage unit is grounded;
a first switch unit, wherein a first end of the first switch unit is coupled to the first end of the second energy storage unit, a second end of the first switch unit is coupled to the light-emitter apparatus, and the first switch unit is configured to selectively use the second energy storage unit to drive the light-emitter apparatus to emit the light; and
a second switch unit, wherein the second switch unit is configured to selectively discharge the second energy storage unit.

13. The drive circuit of claim 12, wherein the first monitor unit monitors whether the voltage of the first end of the second energy storage unit reaches the second threshold.

14. The drive circuit of claim 12, wherein the switch controller unit further comprises:
a third switch unit, wherein a first end of the third switch unit is connected to the supply voltage, a second end of the third switch unit is coupled to the first end of the second energy storage unit and the first end of the first switch unit, and the second end of the first switch unit is coupled to an anode of the light-emitter apparatus.

15. The drive circuit of claim 12, wherein the second switch unit comprises:
a third MOS transistor, wherein a gate of the third MOS transistor is coupled to an output end of the safety controller unit, a drain of the third MOS transistor is connected to the supply voltage, and a source of the third MOS transistor is grounded.

16. The drive circuit of claim 12, wherein the second switch unit comprises:
a fourth MOS transistor, wherein a gate of the fourth MOS transistor is connected to the first control signal, and a source of the fourth MOS transistor is connected to the first voltage;
a fifth MOS transistor, wherein a gate of the fifth MOS transistor is connected to a second control signal, a source of the fifth MOS transistor is grounded, and a drain of the fifth MOS transistor is coupled to a drain of the fourth MOS transistor;
a sixth MOS transistor, wherein a gate of the sixth MOS transistor is connected to the second control signal, a source of the sixth MOS transistor is connected to a second voltage, and the second voltage is less than the first voltage; and
the third MOS transistor, wherein the gate of the third MOS transistor is coupled to a drain of the sixth MOS transistor and the drain of the fourth MOS transistor, the drain of the third MOS transistor is connected to the supply voltage, and the drain of the third MOS transistor is grounded.

17. The drive circuit of claim 16, wherein the second switch unit further comprises:
a first driver, wherein an input end of the first driver inputs a third control signal, and an output end of the first driver outputs the first control signal; and
a second driver, wherein an input end of the second driver is coupled to the output end of the safety controller unit, and an output end of the second driver outputs the second control signal.

18. The drive circuit of claim 17, wherein the second switch unit further comprises:
a level shifter, wherein an input end of the level shifter is coupled to the output end of the safety controller unit, and an output end of the level shifter outputs the third control signal.

19. The drive circuit of claim 1, wherein the first monitor unit comprises:
a second voltage division subunit configured to divide the supply voltage to output a voltage division signal;
a digital-to-analog converter, wherein the digital-to-analog converter is configured to provide reference voltage; and
a third comparator, wherein a negative input end of the third comparator is connected to the voltage division signal, and a positive input end of the third comparator is coupled to an output end of the digital-to-analog converter.

20. The drive circuit of claim 19, wherein the first monitor unit comprises:
a second filter subunit, coupled to an output end of the second voltage division subunit and configured to filter the voltage division signal.

21. A drive method for a LiDAR, wherein the LiDAR comprises a light-emitter apparatus, and the drive method comprises:
monitoring at least one of light-emitting energy of the light-emitter apparatus or light-emitting duration of the light-emitter apparatus; and
controlling the light-emitter apparatus to stop emitting light when the light-emitting energy reaches a first threshold, and/or the light-emitting duration reaches a second threshold.

22. The drive method of claim 21, wherein monitoring the light-emitting duration of the light-emitter apparatus comprises:
monitoring whether the voltage of the light-emitter apparatus reaches a light-emitting voltage threshold of the light-emitter apparatus.

23. A LiDAR, comprising a light-emitter apparatus, wherein the LiDAR further comprises the drive circuit of any of claims 1 to 20.
